# EUROPEAN PATENT SPECIFICATION

(11) **EP 0 585 125 B1**
(45) Date of publication and mention of the grant of the patent: **29.12.1999**
(21) Application number: 93306772.0
(22) Date of filing: 26.08.1993
(51) Int. Cl.: H01L 21/20, H01L 21/76

(54) **A thin film semiconductor device and method of manufacture**
Dünnschicht-Halbleiteranordnung und Verfahren zu ihrer Herstellung
Dispositif semi-conducteur à couches minces et procédé de sa fabrication

(30) Priority: 26.08.1992 JP 22764592
(43) Date of publication of application: 02.03.1994
(73) Proprietor: SEIKO INSTRUMENTS INC., Tokyo 136 (JP)
(72) Inventor: Matsushita, Katsuki, c/o Seiko Instruments Inc., Koto-ku, Tokyo (JP); Senbonmatsu, Shigeru, c/o Seiko Instruments Inc., Koto-ku, Tokyo (JP); Yamazaki, Tsuneo, c/o Seiko Instruments Inc., Koto-ku, Tokyo (JP); Iwaki, Tadao, c/o Seiko Instruments Inc., Koto-ku, Tokyo (JP); Takano, Ryuichi, c/o Seiko Instruments Inc., Koto-ku, Tokyo (JP)
(74) Representative: Sturt, Clifford Mark

(56) References cited:
- EP-A- 0 299 087
- US-A- 4 070 230
- US-A- 4 266 334
- US-A- 4 599 970
- US-A- 4 756 592

## Description

The present invention relates to a thin film semiconductor device and its method of manufacture. In particular, but not exclusively, the present invention relates to the method of manufacturing a thin film semiconductor device incorporated in an active matrix type liquid crystal display device used mainly for a directly viewing type display apparatus or a projection type display apparatus.

A conventional method of manufacturing a thin film semiconductor device to be incorporated in the active matrix type liquid crystal display device is composed of the following steps:
(A) Making a single crystal semiconductor layer formed on a single crystal semiconductor substrate containing an oxide film between them into a thin film semiconductor circuit layer by means of a semiconductor fine processing;
(B) Sticking together the thin film semiconductor circuit layer and a support substrate with an adhesive layer between them; and
(C) Removing the single crystal semiconductor substrate by means of grinding or etching while leaving the oxide film layer of the single crystal semiconductor substrate and the thin film semiconductor circuit layer.

However, the above-mentioned conventional manufacturing method has the following problems.

When removing a single crystal semiconductor substrate by means of the former manufacturing method, first, a thickness of 625µm is shaved off to about 125µm by means of grinding and then, the rest of it is removed by means of anisotropic etching while using the oxide layer as a stopper layer. In this case there is a problem in that before the etching is finished the thin film semiconductor circuit layer may be destroyed by stripping off part of the thin film semiconductor circuit layer from its circumference area. This is because the etching agent can penetrate into the boundary face between the support substrate and the adhesive layer at the circumference and erode the adhesive layer as the etching proceeds. Thus, the thickness of the single crystal semiconductor substrate is reduced from that intended.

In addition, when there is a large difference in the levels of a pattern of the thin film semiconductor circuit layer, there is also a problem that according to the progress of the etching the stress is concentrated on the part having the difference in levels of the pattern. This is exacerbated when the thickness of the single crystal semiconductor substrate is reduced, so that the difference in levels is more pronounced, and exfoliation of the thin film semiconductor circuit layer begins starting from that part.

An object of the present invention, which was made to solve the above-mentioned former problems, is to provide a new method for manufacturing a thin film semiconductor device by removing the single crystal semiconductor substrate in an improved manner while leaving the integrity of the oxide film layer and the thin film semiconductor circuit layer intact.

According to the present invention there is provided a method of manufacturing a thin film semiconductor device comprising:
bonding a thin film semiconductor circuit layer, which is formed on an oxide film layer formed on a single crystal semiconductor substrate, to a support substrate with an adhesive; and
removing the single crystal semiconductor substrate while leaving the oxide film layer and the thin film semiconductor circuit layer, characterised in that the adhesive is composed of a fluorine-containing epoxy family adhesive.

Thus, the thin film semiconductor circuit layer and the support substrate are arranged so as to contain in between the oxide film layer and adhered together by means of a fluorine-containing epoxy family resin adhesive. Then the single crystal semiconductor substrate is removed while leaving the oxide film layer and the thin film semiconductor circuit layer. The thin film semiconductor circuit layer and support substrate may be adhered together by means of the fluorine-containing epoxy family adhesive after forming a smoothing layer having silicon dioxide as the main ingredient on the thin film semiconductor circuit layer.

In the thin film semiconductor device composed as described above, since a thin film semiconductor circuit layer and the support substrate formed on the single crystal semiconductor substrate containing the oxide film layer in between are adhered together by means of a fluorine-containing epoxy family adhesive of high chemical resistivity, when etching off the single crystal semiconductor substrate by using the oxide film layer as a stopper layer, the adhesive layer is not eroded and the etching process can be finished without exfoliation or destruction of the thin film semiconductor circuit layer at its circumference. In addition, after the smoothing layer, having silicon dioxide as the main ingredient, has been formed on the thin film semiconductor circuit layer on a single crystal semiconductor substrate with an oxide film layer between the circuit layer and the substrate, the support substrate is adhered on the smoothing layer by means of the fluorine-containing epoxy family adhesive. Thus, when etching off the single crystal semiconductor substrate by using the oxide film layer as a stopper, any differences in the levels on the thin film semiconductor circuit layer are smoothed by the smoothing layer and so no stress is concentrated on the part with the level difference. As a result, even when the etching proceeds and the thickness of the single crystal semiconductor substrate is reduced, the thin film semiconductor circuit layer can be protected from exfoliation.

Embodiments of the present invention will now be described with reference to the accompanying drawings, of which:
Figs. 1(A) to 1(E) show cross-sectional views of a first embodiment of a method for manufacturing thin film semiconductor devices of the present invention;
Figs. 2(A) to 2(F) show cross-sectional views of a second embodiment of a method for manufacturing thin film semiconductor devices of the present invention;
Fig. 3 is an enlargement of a cross-sectional view in an embodiment of a method for manufacturing thin film semiconductor devices of the present invention;
Fig. 4 is an explanatory figure showing one way for making a support substrate and a thin film semiconductor circuit layer adhere to each other;
Fig. 5 is an explanatory figure showing a method for applying an adhesive to a support substrate or a thin film semiconductor circuit layer;
Fig. 6 is an explanatory figure showing another method for applying an adhesive to a support substrate or a thin film semiconductor circuit layer;
Fig. 7 is an explanatory figure showing one way for making a support substrate and a thin film semiconductor circuit layer adhere to each other;
Fig. 8 is an explanatory figure showing an outline of an apparatus for injecting an adhesive into a slit;
Fig. 9 is an explanatory figure showing one way for sticking together a support substrate and a thin film semiconductor circuit layer; and
Fig. 10 is an explanatory figure showing an outline of a vacuum sticking apparatus.

Embodiments of the invention are described in the following, referring to the drawings.

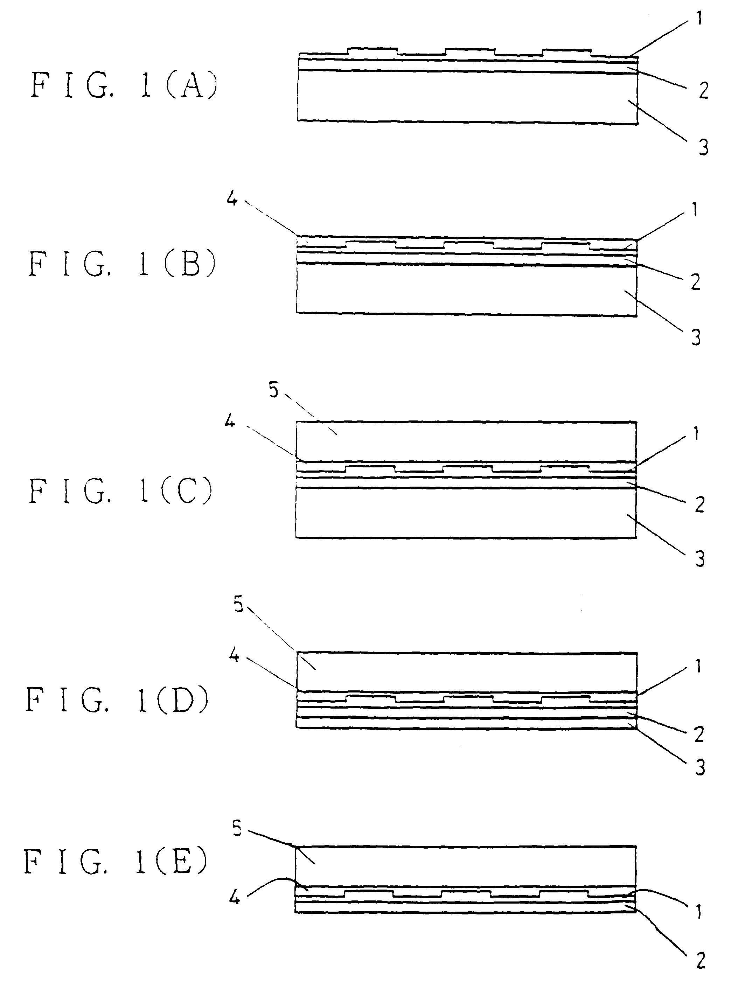

Figs. 1(A) to (E) show cross-sectional views of a first embodiment of thin film semiconductor device manufacturing methods of the invention.

First, as shown in Fig. 1 (A), for example, an oxide film layer 2, made of a silicon oxide film, is formed on a single crystal semiconductor substrate 3, made of silicon, on which is formed a thin film semiconductor circuit layer 1. The semiconductor circuit layer 1 is formed with an integrated circuit on a silicon layer by means of a semiconductor fine technology.

Next, as shown in Fig. 1 (B), an adhesive layer is formed with a fluorine-containing epoxy family adhesive 4. And as shown in Fig. 1 (C), the thin film semiconductor circuit layer 1 and a support substrate 5 are stuck together with the fluorine-containing epoxy family adhesive 4, and then the adhesive is set. The hardened support substrate is made of an insulating material such as glass, quartz or the like. In this case, either of an ultraviolet ray setting type, thermosetting type or 2-liquid setting type may be used as a setting mechanism for the fluorine-containing epoxy family adhesive 4 to stick together the thin film semiconductor circuit layer 1 and the support substrate 5.

Fig. 1 (D) shows when the single crystal semiconductor substrate 3 is removed while leaving the oxide layer 2 and the thin film semiconductor circuit layer 1. As a method for removing the single crystal semiconductor substrate 3, methods such as grinding, etching or the like can be considered but in the embodiment, about 80% of the original thickness of the single crystal semiconductor substrate 3 was removed by grinding.

Fig. 1 (E) shows when the rest of the single crystal semiconductor substrate 3 in Fig. 1 (D) has been removed. Etching is used as a removing method, and at this time the oxide film layer 2 can be used as a stopper layer for the etching.

In the thin film semiconductor device manufactured as described above, the etching can be finished without exfoliation of the single crystal semiconductor substrate from its circumference, since the fluorine containing epoxy family adhesive is not eroded by the etching agent even when the etching proceeds to reduce the thickness of the single crystal semiconductor substrate.

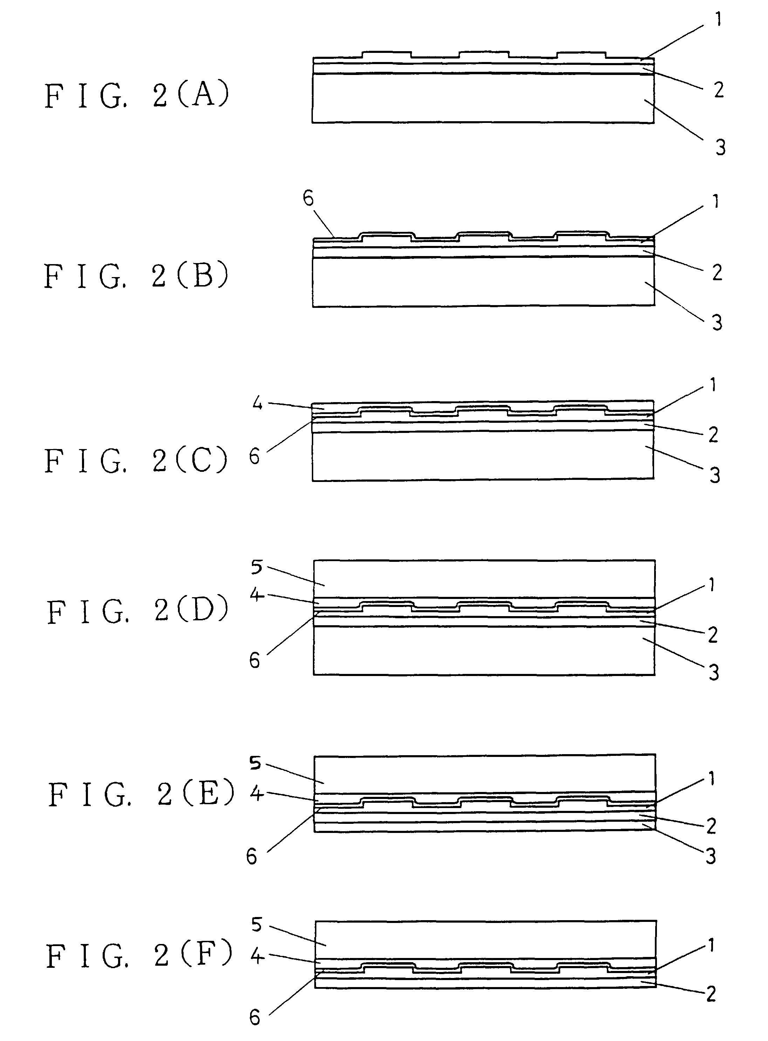

Figs. 2 (A) to (F) show cross-sectional views of a second embodiment of thin film semiconductor device manufacturing method of the invention.

First, as shown in Fig. 2 (A), for example, an oxide film layer 2 made of a silicon oxide film is formed on a single crystal semiconductor substrate 3 made of silicon. A thin film semiconductor circuit layer 1 is formed thereon with an integrated circuit on a silicon layer by means of a semiconductor fine technology.

Next, as shown in Fig. 2 (B), the rough surface of the thin film semiconductor circuit layer 1 is smoothed by forming a smoothing layer 6 having silicon dioxide as the main ingredient on the thin film semiconductor circuit layer 1 by means of a spin-coating method or the like. Next, as shown in Fig. 2 (C), an adhesive layer is formed by means of a fluorine-containing epoxy family adhesive 4.

As shown in Fig. 2 (D), the thin film semiconductor circuit layer 1 and a support layer 5 are stuck together through the smoothing layer 6 by means of the fluorine-containing epoxy family adhesive 4, and thereafter the adhesive is set. The support substrate 5 is made of hardened insulating material such as glass, quartz or the like. In this case, either of an ultraviolet ray setting type, thermosetting type and 2-liquid setting type may be used as a setting mechanism of the fluorine containing epoxy family adhesive 4 to stick together the thin film semiconductor circuit layer 1 and the support substrate 5.

Fig. 2 (E) shows when the single crystal semiconductor substrate 3 is removed while leaving the oxide layer 2 and the thin film semiconductor circuit layer 1. Grinding, etching or the like can be considered as a method for removing the single crystal semiconductor substrate 3, but in the embodiment, about 80% of the original thickness of the single crystal semiconductor substrate 3 was removed by grinding.

Fig. 2 (F) shows when the rest of the single crystal semiconductor substrate 3 in Fig. 2 (E) has been removed. Etching is used as a removing method, and at this time the oxide film layer 2 can be used as a stopper layer for the etching.

In the thin film semiconductor device manufactured as described above, the etching can be finished without exfoliation of the single crystal semiconductor substrate, since no stress is concentrated on the part with the level differences on the surface of the thin film semiconductor circuit layer by smoothing the rough surface by means of the smoothing layer even when the etching proceeds to reduce the thickness of the single crystal semiconductor substrate.

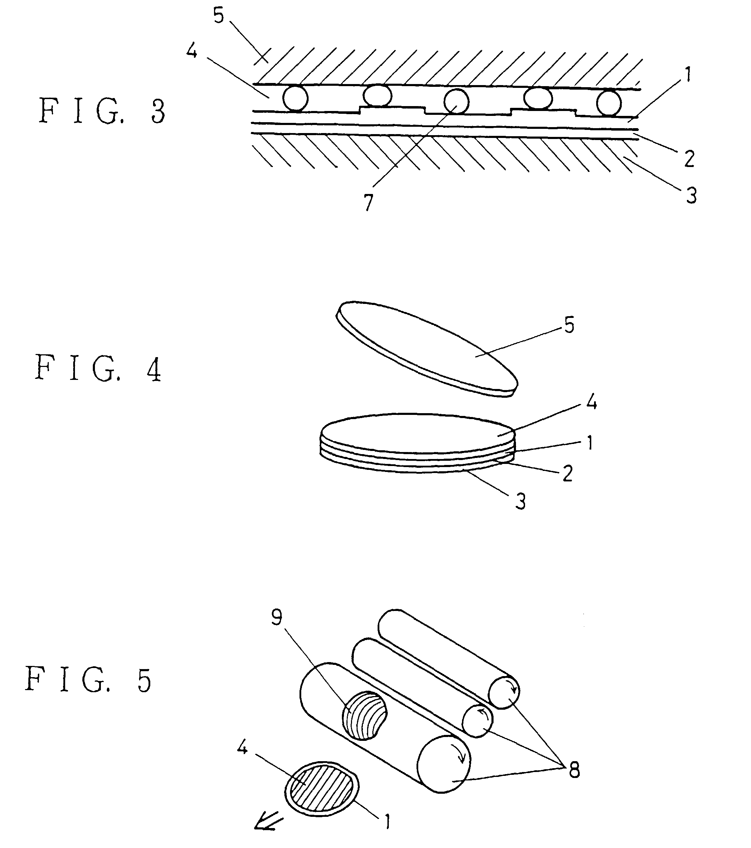

Fig. 3 is a cross-sectional view of a thin film semiconductor device in which the thickness of the fluorine-containing epoxy family adhesive has been controlled in the first or second embodiment of the present invention. The thickness of the adhesive can be controlled either by applying the fluorine-containing epoxy family adhesive 4 after mixing transparent plastic particles 7 in it or by applying the fluorine-containing epoxy family adhesive 4 after spreading the transparent plastic particles 7 in a specified density on the circuit layer 1 and then sticking the support substrate on it. Since the single crystal semiconductor substrate 3 can be uniformly removed by grinding or etching by maintaining a constant thickness in this manner, the thin film semiconductor circuit layer can be more reliably protected from exfoliation.

Fig. 4 is an explanatory figure showing one of the methods for sticking together a support substrate and a thin film semiconductor circuit layer in the first or second embodiment of the present invention. The adhering process is completed by applying a fluorine-containing epoxy family adhesive 4 to at least one of a support substrate 5 and a thin film semiconductor circuit layer 1, sticking them together face to face, and then hardening the adhesive.

Fig. 5 is an explanatory figure showing one method for applying an adhesive to a support substrate or a thin film semiconductor circuit layer in Fig. 4. A relief 9 is formed in a specified shape (the shape it is desired to apply) and is stuck on a roll 8. The fluorine-containing epoxy family adhesive 4 is transferred onto the relief 9 from the roll 8. The adhesive 4 is transferred onto the thin film semiconductor circuit layer in the specified pattern from the relief 9 on the roll 8 by moving the roll 8 or the thin film semiconductor circuit layer 1 relatively to each other after transferring the adhesive 4.

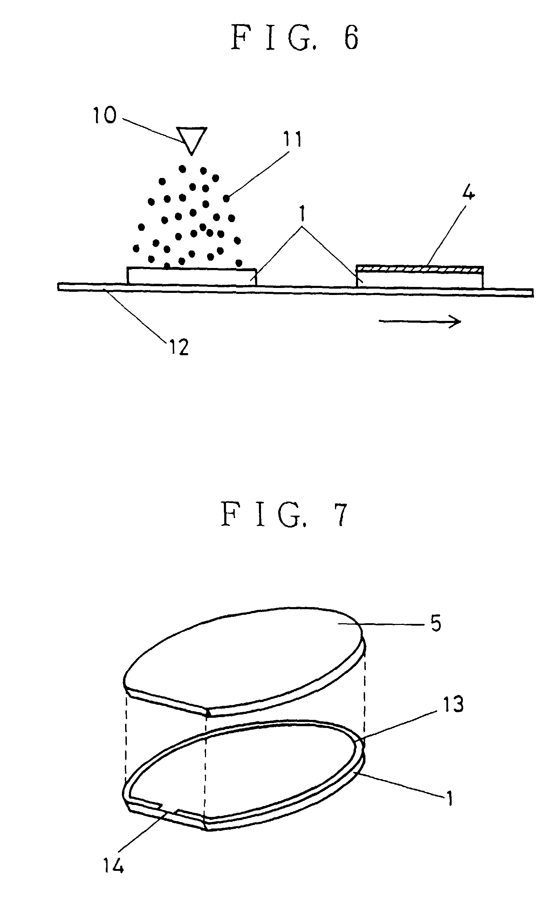

Fig. 6 is an explanatory figure showing another method for applying the adhesive to the support substrate or the thin film semiconductor circuit layer in Fig. 4. The fluorine-containing epoxy family adhesive 4 is diluted with a solution and is deposited on the support substrate 5 or the thin film semiconductor circuit layer 1. The adhesive is deposited in a mist 11 by being sprayed from a nozzle 10. At this time the support substrate 5 or the thin film semiconductor circuit layer 1 is conveyed by a conveyer belt 12 to move from left to right in the figure. In the course of conveying the support substrate 5 or the thin film semiconductor circuit layer 1 having the adhesive deposited on it from the mist by means of the conveyer belt 12, the solution evaporates and only the adhesive is uniformly applied.

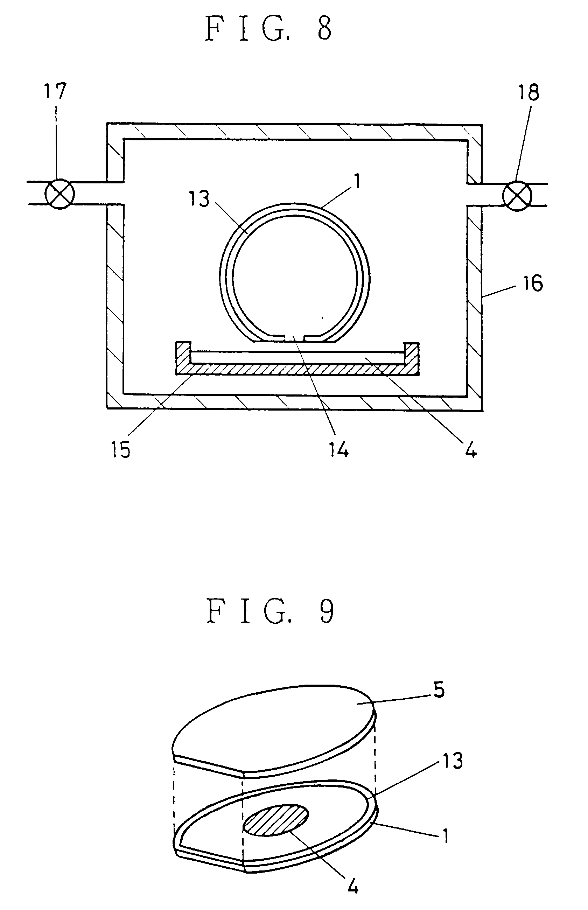

Fig. 7 and 8 are figures explaining methods for sticking together the support substrate and the thin film semiconductor circuit layer in the first or second embodiment of the present invention. The support substrate 5 and the thin film semiconductor circuit layer 1 are stuck together face to face after forming a sealing agent 13 in a shape of a frame on the circumference of the wafer. At this time an inlet 14 is formed in a part of the frame-shaped sealing agent. Thermosetting resin, ultraviolet ray setting resin or the like is used as the frame-shaped sealing agent. A space or slit is formed between the support substrate 5 and the thin film semiconductor circuit layer 1 by sticking them together after spreading transparent plastic particles (not shown in the figure) on one of their faces when facing each other before sticking them together.

Fig. 8 is an explanatory figure showing an outline of an apparatus for injecting the adhesive into the slit. The thin film semiconductor circuit layer 1 and the support substrate 5 which have a slit formed between them by the frame-shaped sealing agent 13 are hung inside a pressure container 16 so that the inlet 14 points downward. This container 16 is connected with an exhaust system through an exhaust valve 17 and can inhale air through an exhaust valve 18. An adhesive storing container 15 containing the fluorine-containing epoxy family adhesive 4 is placed at the bottom of the pressure container 16.

In the above-mentioned system, the pressure container 16, the thin film semiconductor circuit layer 1 and the support substrate 5 are, first, exhausted by opening the exhausting valve 17 and making the exhausting system operate. By this, gas inside the slit between the thin film semiconductor circuit layer 1 and the support substrate 5 is quickly exhausted to a vacuum state. At this time the air which has dissolved in the fluorine-containing epoxy family adhesive 4 in the adhesive storing container 15 can be also exhausted. After the exhaustion has been fully made, the exhausting valve 17 is closed and the inlet 14 of the thin film semiconductor circuit layer 1 and support substrate 5 which hangs downward is immersed in the fluorine containing epoxy family adhesive 4.

Next, when the inhaling valve 18 is opened and air or nitrogen gas flows into the pressure container, the surface of the fluorine-containing epoxy family adhesive 4 is pressurised. By this, the fluorine containing epoxy family adhesive 4 is sucked or injected into the slit between the thin film semiconductor circuit layer 1 and the support substrate 5. After the slit has been filled with the fluorine-containing epoxy family adhesive 4, the thin film semiconductor circuit layer 1 and the support substrate 5 are taken out of the pressure container 15. The fluorine-containing epoxy family adhesive 4 then is cured to complete the adhering process. According to such a method, since an adhesive layer of uniform thickness having no air bubble can be formed, a thin film semiconductor circuit layer and a support layer can be firmly stuck together.

Fig. 9 is an explanatory figure showing another method for sticking together the thin film semiconductor circuit layer and the support substrate in the first or second embodiment of the present invention. First, a frame-shaped sealing material 13 is formed on the support substrate 5 or the thin film semiconductor circuit layer 1. Thermosetting resin, ultraviolet ray setting resin or the like is used as the frame-shaped sealing material. Next, the fluorine-containing epoxy family adhesive 4 is dropped once or a bit at a time nearly in the middle of the area surrounded by the sealing material 13 on the support substrate 5 or the thin film semiconductor circuit layer 1. In order to keep the space uniform between the support substrate 5 and the thin film semiconductor circuit layer 1, the fluorine-containing epoxy family adhesive 4 is previously mixed with transparent plastic particles (not shown in the figure) or the fluorine-containing epoxy family adhesive 4 is dropped after spreading the transparent plastic particles on the support layer 5 or the thin film semiconductor circuit layer 1.

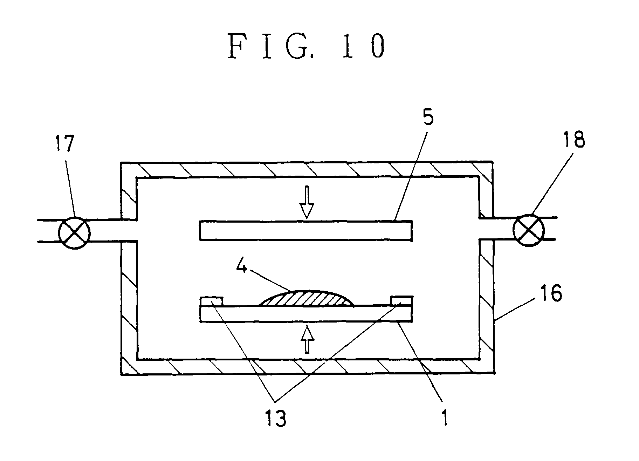

Fig. 10 is a figure showing an outline of a vacuum sticking apparatus. One of the support substrate 5 and the thin film semiconductor circuit layer 1 which has the frame-shaped sealing material formed on it and has the fluorine-containing epoxy family adhesive 4 dropped on it, are disposed with their faces to be stuck together facing each other so that the layer with the frame and adhesive is under the other layer. In order to stick both the layers together, first, the pressure container 16 is exhausted by opening the exhausting valve 17 and making the exhausting system operate. At this time the air which has dissolved in the fluorine-containing epoxy family adhesive 4 dropped on the thin film semiconductor circuit layer 1 or the support substrate 5 also can be exhausted. After the exhaustion is fully made, the thin film semiconductor circuit layer 1 and the support substrate 5 are stuck together. Next, after restoring the pressure inside the pressure container to the atmospheric pressure by opening the inhaling valve 18 and letting air or nitrogen gas flow in, the thin film semiconductor circuit layer 1 and the support substrate 5 are taken out. The adhering process then is completed by curing the fluorine-containing epoxy family adhesive 4 and the sealing material 13. According to a method such as this, since an adhesive layer of uniform thickness having no air bubbles can be formed, not only a thin film semiconductor circuit layer and a carrier layer can be firmly stuck together, but also the expensive fluorine-containing epoxy family adhesive can be saved.

As described above, the invention has an excellent effect in that thin film semiconductor devices can be manufactured with a high yield rate by sticking together a thin film semiconductor circuit layer and a carrier layer by means of a fluorine-containing epoxy family adhesive of high chemical resistivity.

## Claims

1. A method of manufacturing a thin film semiconductor device comprising:
bonding a thin film semiconductor circuit layer (1), which is formed on an oxide film layer (2) formed on a single crystal semiconductor substrate (3), to a support substrate (5) with an adhesive (4); and
removing the single crystal semiconductor substrate while leaving the oxide film layer and the thin film semiconductor circuit layer, characterised in that the adhesive is composed of a fluorine-containing epoxy family adhesive.

2. A method of manufacturing a thin film semiconductor device according to claim 1, in which bonding the circuit layer includes forming a smoothing layer (6) on the thin film semiconductor circuit layer, wherein the smoothing layer is chiefly composed of a silicon dioxide material.

3. A method of manufacturing a thin film semiconductor device according to claim 1 or 2, in which the fluorine-containing epoxy family adhesive is one of an ultraviolet ray setting type, a thermosetting type or a 2-liquid setting type.

4. A method of manufacturing a thin film semiconductor device according to any one of claims 1, 2 or 3, in which the adhesive includes transparent plastic particles (7) having a specified shape and predetermined density so as to control a thickness of the adhesive.

5. A method of manufacturing a thin film semiconductor device according to any one of the preceding claims, in which bonding includes the circuit layer applying the adhesive on at least one of the thin film semiconductor circuit layer and the support substrate, disposing the thin film semiconductor circuit layer and the support substrate opposite to each other, sticking them together and hardening the adhesive.

6. A method of manufacturing a thin film semiconductor device according to claim 5, in which applying the adhesive uses an offset printing method as a means for applying the adhesive.

7. A method of manufacturing a thin film semiconductor device according to claim 5, in which applying the adhesive includes:
diluting the adhesive with a solution, atomising the solution so as to obtain liquid-drops, and depositing the liquid-drops onto at least one of the thin film semiconductor circuit layer and the support substrate.

8. A method of manufacturing a thin film semiconductor device according to any one of claims 1 to 4, in which bonding the circuit layer includes:
providing a frame-shaped sealing material having at least one inlet on a surface of at least one of the thin film semiconductor circuit layer and the support substrate, arranging the thin film semiconductor circuit layer and the support substrate opposite to each other, sticking them together so as to provide a slit in a composite substrate, putting the composite substrate into a container together with an adhesive-storing-container holding the adhesive, immersing the inlet in the adhesive-storing-container while the gas in the container is evacuated, injecting the adhesive into the slit through the inlet of the composite substrate by introducing gas into the container, and hardening the adhesive.

9. A semiconductor device comprising:
a thin film semiconductor circuit layer (1) formed on an insulating layer (2), and a support substrate (5) formed on the thin film semiconductor circuit layer by interposing an adhesive (4), characterised in that the adhesive is composed of a fluorine-containing epoxy family adhesive.

10. A semiconductor device according to claim 9, further comprising a smoothing layer (6) formed between the thin film semiconductor circuit layer and the adhesive.

## Patentansprüche

1. Verfahren zum Herstellen eines Dünnfilm-Halbleiter-Bauelements, umfassend:
Anbringen einer Dünnfilm-Halbleiterschaltungs-Schicht (1), welche aus einer auf einem einkristallinen Halbleiter-Substrat (3) ausgebildeten Oxidfilm-Schicht (2) gebildet ist, an einem Trägersubstrat (5) durch einen Klebstoff (4); und
Entfernen des einkristallinen Halbleiter-Substrats während die Oxidfilm-Schicht und die Dünnfilm-Halbleiterschaltungs-Schicht zurückgelassen werden, **dadurch gekennzeichnet**, daß der Klebstoff aus einem fluorhaltigen Epoxidharzfamilien-Klebstoff besteht.

2. Verfahren zum Herstellen eines Dünnfilm-Halbleiter-Bauelements nach Anspruch 1, wobei das Anbringen der Schaltungsschicht das Ausbilden einer Glättungsschicht (6) auf der Dünnfilm-Halbleiterschaltungs-Schicht umfaßt, wobei die Glättungsschicht vorwiegend aus einem Siliciumdioxid-Material besteht.

3. Verfahren zum Herstellen eines Dünnfilm-Halbleiter-Bauelements nach Anspruch 1 oder 2, wobei der fluorhaltige Epoxidharzfamilien-Klebstoff von einem Typ ist, der bei ultravioletter Strahlung aushärtet, der thermisch aushärtet oder der eine Zweikomponentenhärtung erfährt.

4. Verfahren zum Herstellen eines Dünnfilm-Halbleiter-Bauelements nach Anspruch 1, 2 oder 3, wobei der Klebstoff transparente Kunststoffpartikel (7) mit spezieller Form und vorbestimmter Dichte umfaßt, um die Dicke des Klebstoffs einzustellen.

5. Verfahren zum Herstellen eines Dünnfilm-Halbleiter-Bauelements nach einem der vorangehenden Ansprüche, wobei das Anbringen der Schaltungsschicht umfaßt, daß der Klebstoff auf der Dünnfilm-Halbleiterschaltungs-Schicht oder/und auf dem Trägersubstrat aufgebracht wird, daß die Dünnfilm-Halbleiterschaltungs-Schicht und das Trägersubstrat einander gegenüberliegend angeordnet werden, daß diese zusammengeklebt werden und daß der Klebstoff aushärtet.

6. Verfahren zum Herstellen eines Dünnfilm-Halbleiter-Bauelements nach Anspruch 5, wobei das Aufbringen des Klebstoffs ein Offset-Druckverfahren als Mittel zum Aufbringen des Klebstoffs verwendet.

7. Verfahren zum Herstellen eines Dünnfilm-Halbleiter-Bauelements nach Anspruch 5, wobei das Aufbringen des Klebstoffs umfaßt:
Lösen des Klebstoffs mit einer Lösung, Zerstäuben der Lösung, um Flüssigkeitstropfen zu erhalten, und Ablagern der Flüssigkeitstropfen auf der Dünnfilm-Halbleiterschaltungs-Schicht oder/und auf dem Trägersubstrat.

8. Verfahren zum Herstellen eines Dünnfilm-Halbleiter-Bauelements nach einem der Ansprüche 1 bis 4, wobei das Anbringen der Schaltungsschicht umfaßt:
Vorsehen eines rahmenförmigen Dichtmaterials mit zumindest einem Einlaß an einer Oberfläche der Dünnfilm-Halbleiterschaltungs-Schicht oder/und des Trägersubstrats,
Anordnen der Dünnfilm-Halbleiterschaltungs-Schicht und des Trägersubstrats einander gegenüberliegend, Zusammenkleben derselben, derart, daß ein Spalt in einem Verbundsubstrat ausgebildet wird, Einbringen des Verbundsubstrats in einen Behälter zusammen mit einem den Klebstoff haltenden Klebstoffspeicherbehälter, Eintauchen des Einlasses in den Klebstoffspeicherbehälter während das Gas im Behälter evakuiert wird, Einspritzen des Klebstoffs in den Spalt durch den Einlaß des Verbundsubstrats durch Einführen von Gas in den Behälter und Aushärten des Klebstoffs.

9. Halbleiterbauelement, umfassend:
eine an einer lsolationsschicht (2) ausgebildete Dünnfilm-Halbleiterschaltungs-Schicht (1) und
ein an der Dünnfilm-Halbleiterschaltungs-Schicht durch Zwischenschalten eines Klebstoffs (4) ausgebildetes Trägersubstrat (5), **dadurch gekennzeichnet**, daß der Klebstoff aus einem fluorhaltigen Epoxidharzfamilien-Klebstoff besteht.

10. Halbleitervorrichtung nach Anspruch 9, ferner umfassend eine Glättungsschicht (6), welche zwischen der Dünnfilm-Halbleiterschaltungs-Schicht und dem Klebstoff ausgebildet ist.

## Revendications

1. Procédé de fabrication d'un dispositif semi-conducteur à couches minces comprenant les étapes consistant à :
lier une couche de circuit semi-conductrice à couche mince (1), qui est formée sur une couche d'oxyde (2) elle-même formée sur un substrat semi-conducteur monocristalin (3), à un substrat de base (5) grâce à un adhésif (4) ; et
enlever le substrat semi-conducteur monocristalin tout en laissant la couche d'oxyde et la couche de circuit semi-conductrice à couche mince, caractérisé en ce que l'adhésif est constitué d'un adhésif appartenant à la famille des époxy contenant du fluor.

2. Procédé de fabrication d'un dispositif semi-conducteur à couche mince selon la revendication 1, dans lequel la liaison de la couche de circuit comprend la formation d'une couche de lissage (6) sur la couche de circuit semi-conductrice à couche mince, la couche de lissage étant principalement constituée d'un matériau en dioxyde de silicium.

3. Procédé de fabrication d'un dispositif semi-conducteur à couche mince selon la revendication 1 ou 2, dans lequel l'adhésif appartenant à la famille des époxy contenant du fluor est d'un type durcissable aux rayons ultraviolets, d'un type thermofixable ou bien durcissable à deux liquides.

4. Procédé de fabrication d'un dispositif semi-conducteur à couche mince selon l'une quelconque des revendications 1, 2 ou 3, dans lequel l'adhésif comprend des particules plastiques transparentes (7) ayant une forme spécifique et une densité prédéterminée afin de contrôler une épaisseur de l'adhésif.

5. Procédé de fabrication d'un dispositif semi-conducteur à couche mince selon l'une quelconque des revendications précédentes, dans lequel la liaison comprend l'application de la couche de circuit par un adhésif sur l'un au moins des éléments parmi la couche de circuit semi-conductrice à couche mince et le substrat de base, en plaçant la couche de circuit semi-conductrice à couche mince et le substrat de base à l'opposé l'un de l'autre, en les collant l'un à l'autre et en renforçant l'action de la colle.

6. Procédé de fabrication d'un dispositif semi-conducteur à couche mince selon la revendication 5, dans lequel l'application de l'adhésif utilise un procédé d'impression offset comme moyen d'application de l'adhésif.

7. Procédé de fabrication d'un dispositif semi-conducteur à couche mince selon la revendication 5, dans lequel l'application de l'adhésif comprend :
la dilution de l'adhésif avec une solution, en atomisant la solution de manière à obtenir des gouttes de liquide et en plaçant les gouttes de liquide sur l'un au moins des éléments parmi la couche de circuit semi-conductrice à couche mince et le substrat de base.

8. Procédé de fabrication d'un dispositif semi-conducteur à couche mince selon l'une quelconque des revendications 1 à 4, dans lequel la liaison à la couche de circuit comprend les étapes consistant :
à fournir un matériau d'étanchéité en forme de cadre ayant au moins une entrée sur une surface de l'un au moins des éléments parmi la couche de circuit semi-conductrice à couche mince et le substrat de base, à placer la couche de circuit semi-conductrice à couche mince et le substrat de base à l'opposé l'un de l'autre, en les collant l'un à l'autre afin de ménager une fente dans un substrat composite, à placer le substrat composite dans un conteneur avec un conteneur de stockage d'adhésif contenant de l'adhésif, à immerger l'entrée dans le conteneur de stockage d'adhésif tandis que le gaz présent dans le conteneur est évacué, à injecter l'adhésif dans la fente à travers l'entrée du substrat composite en introduisant du gaz dans le conteneur, et à durcir l'adhésif.

9. Dispositif semi-conducteur comprenant :
une couche de circuit semi-conductrice à couche mince (1) formée sur une couche d'isolation (2) et un substrat de base (5) formé sur une couche de circuit semi-conductrice à couche mince en interposant un adhésif (4), caractérisé en ce que l'adhésif est constitué d'un adhésif appartenant à la famille des époxy contenant du fluor.

10. Dispositif semi-conducteur selon la revendication 9, comprenant en outre une couche de lissage (6) formée entre la couche de circuit semi-conductrice à couche mince et l'adhésif.
